# EUROPEAN PATENT APPLICATION

(11) **EP 3 468 039 A1**
(43) Date of publication of application: **10.04.2019**
(21) Application number: 17194764.1
(22) Date of filing: 04.10.2017
(51) Int. Cl.: H03K 17/18

(54) **INDICATOR ARRANGEMENT FOR AN ELECTRONIC DEVICE**

(71) Applicant: Vestel Elektronik Sanayi ve Ticaret A.S., 45030 Manisa (TR)
(72) Inventor: Sariarslan, Muhammet Kürsat, 45030 Manisa (TR); Öcal, Ömür, 45030 Manisa (TR)
(74) Representative: Schmidt, Steffen J.

(57) **Abstract**

The present disclosure relates to an indicator arrangement (100) for indicating a state associated with a button (102) of an electronic device. The indicator arrangement (100) comprises a button-related magnet (104) arranged to be movable by the button (102) when the button (102) is pressed, an indicator element (106) switchable between at least two states associated with the button (102), and a switching arrangement (108) configured to switch the indicator element (106) using electrical energy induced by a magnetic field of the button-related magnet (104) when the button (102) is pressed.

## Description

### Technical Field

The present disclosure generally relates to the field of electronic devices. More particularly, the present disclosure relates to an indicator arrangement for indicating a state associated with a button of an electronic device and to an electronic device comprising the indicator arrangement.

### Background

Electronic devices are nowadays used for a huge variety of applications in both industry and the private sector. Typical electronic devices include smartphones, tablets, laptops, personal computers and other consumer electronic devices, such as TVs, set-top boxes, refrigerators, cookers, dishwashers, washing machines, air conditioners, and the like.

Most electronic devices comprise visual indicators, such as signal lamps or LEDs, to indicate particular states of the electronic device to the user. Some of these indicators are related to states which can be changed or selected by pressing respective buttons of the device. For example, a laptop or a keyboard typically comprises indicator lamps that indicate whether the "caps lock" or "numlock" keys have been activated or not.

Such visual indicators consume electrical energy and may therefore add to the overall energy consumption of the electronic device. While it is a general goal to reduce the energy consumption of electronic devices - in particular of battery-driven mobile electronic devices - it is an object of the present disclosure to provide an indicator for an electronic device which reduces energy consumption.

### Summary

According to a first aspect of the present disclosure, an indicator arrangement for indicating a state associated with a button of an electronic device is provided. The indicator arrangement comprises a button-related magnet arranged to be movable by the button when the button is pressed, an indicator element switchable between at least two states associated with the button, and a switching arrangement configured to switch the indicator element using electrical energy induced by a magnetic field of the button-related magnet when the button is pressed.

By using electrical energy generated by pressing the button, the indicator element may be switched without making use of the actual power supply of the electronic device and the energy consumption of the electronic device may therefore be reduced. In other words, it may be said that the indicator arrangement produces electrical energy required for switching the indicator element on its own when the button is pressed so that the indicator element may be switched without the need for an external energy source.

Rather than lighted indicators, for example, the indicator element may comprise static visual indications (e.g., static labels) which do not require electrical energy for being permanently displayed to the user. Each of the static visual indications may correspond to a particular state associated with the button and may be visible to the user when the indicator element is in the respective state. In one variant, the indicator element may be switched by moving (e.g., rotating) the indicator element from one indicator position to another so that a particular static visual indication (corresponding to the state into which the indicator element is being switched) is displayed to the user. For example, the indicator element may be switchable between an "ON" and an "OFF" state associated with the button. The static visual indications may then comprise "ON" and "OFF" labels which may be alternatingly displayed to the user by alternatingly moving the indicator element between indicator positions corresponding to the "ON" and "OFF" states.

The electronic device may be any electronic device which comprises at least one button and a corresponding indicator that indicates a state associated with the button, e.g., a state of the electronic device selected by pressing the button. The electronic device may be, but is not limited to, a smartphone, tablet, laptop, personal computer, TV, set-top box, refrigerator, cooker, dishwasher, washing machine, air conditioner, for example. If the electronic device is a laptop or a personal computer, the button may be a key of the corresponding keyboard, for example.

For generating the electrical energy induced by the magnetic field of the button-related magnet, the indicator arrangement may make use of a physical principle according to which an electrical current can be induced in a conducting loop if the conducting loop is exposed to a changing magnetic field. The change in the magnetic field may be effected by moving the conducting loop in and out of the magnetic field or, more generally, by altering the distance between the magnet and the conducting loop, for example.

For generating electrical energy using this principle, the button-related magnet of the indicator arrangement may be moved in relation to a corresponding coil. More specifically, the switching arrangement of the indicator arrangement may comprise a coil, wherein the electrical energy is induced in the coil by the magnetic field of the button-related magnet when the button is pressed. It will be understood that the relative movement between the button-related magnet and the coil may be realized in various ways. In one such variant, the button-related magnet may be attached to the button and may be moved into the stroke direction of the button when the button is pressed. The coil may in this case be arranged in a way that, when the button is pressed, the button-related magnet is moved next to the windings of the coil and, when the button is released, the button-related magnet is removed from the windings of the coil again. In this way, the coil may get into and out of the magnetic field of the button-related magnet when the button is actuated and a corresponding electrical current may thus be induced in the coil. The button-related magnet may be a static magnet.

While it will be understood that the produced electrical energy can be used in various ways for switching the indicator element, in one implementation, the electrical energy may be used for generating a magnetic force, wherein the generated magnetic force may be used to switch the indicator element. The switching arrangement may thus comprise an inductor, wherein the induced electrical energy is transmitted to the inductor, and wherein a magnetic field for switching the indicator element is generated by the inductor using the induced electrical energy. The coil may be electrically connected to the inductor for this purpose.

The indicator element, in turn, may comprise at least one indicator-related magnet, wherein the magnetic field generated by the inductor may exert a magnetic force on the at least one indicator-related magnet to switch the indicator element from one indicator position to another. In particular, when the magnetic field generated by the inductor and a respective one of the at least one indicator-related magnets have different magnetic polarities, the magnetic field generated by the inductor may pull the respective indicator-related magnet to the inductor. Otherwise, when the magnetic field generated by the inductor and the respective indicator-related magnet have the same magnetic polarities, the magnetic field generated by the inductor may push the respective indicator-related magnet away from the inductor. Each of the at least one indicator-related magnet may be a static magnet.

While it will further be understood that the indicator element can have any suitable form which allows moving the indicator element from one indicator position to another, in one implementation, the indicator element may be rotatable and the at least one indicator-related magnet may be arranged at the indicator element to rotate the indicator element from one indicator position to another each time the button is pressed. In one particular such implementation, the indicator element may comprise at least two indicator-related magnets arranged at circumferential portions of the indicator element, wherein each pair among the at least two indicator-related magnets may be spaced apart from one another in a circumferential direction of the indicator element. For example, the inductor element may have a cylindrical form and may be rotatable about a longitudinal axis of the cylinder. The at least two indicator-related magnets may then be arranged at the circumferential portions of the cylinder. In a particular variant, the indicator element may comprise exactly two indicator-related magnets. The two indicator-related magnets may then be arranged at opposite sides of the cylinder and each press of the button may effect a half turn of the indicator element, i.e., from one indicator position to the other.

Each indicator position of the indicator element may correspond to a state associated with the button. In the above example, the indicator element may be switchable between two indicator positions, each corresponding to a state associated with the button. These indicator positions may correspond to an "ON" and an "OFF" state associated with the button, for example, and, more specifically, the state associated with the button may correspond to a state of the electronic device selected by the button. If the electronic device is a keyboard of a laptop or personal computer and the button corresponds to the "numlock" key, for example, the state of the electronic device may correspond to the numeric keypad being active or inactive (i.e., "ON" or "OFF"), depending on the selection made by a user using the "numlock" key of the keyboard.

According to a second aspect of the present disclosure, an electronic device comprising the indicator arrangement according to the first aspect is provided. The electronic device may be one of the electronic devices described above in relation to the indicator arrangement of the first aspect.

### Brief Description of the Drawings

In the following, the present disclosure will further be described with reference to exemplary implementations illustrated in the figures, in which:
- Figure 1: illustrates an exemplary indicator arrangement for indicating a state associated with a button of an electronic device according to the present disclosure; and
- Figs. 2a and 2b: illustrate detailed cross-sectional and perspective views of the indicator element of the indicator arrangement of Figure 1.

### Detailed Description

In the following description, for purposes of explanation and not limitation, specific details are set forth in order to provide a thorough understanding of the present disclosure. It will be apparent to one skilled in the art that the present disclosure may be practiced in other implementations that depart from these specific details.

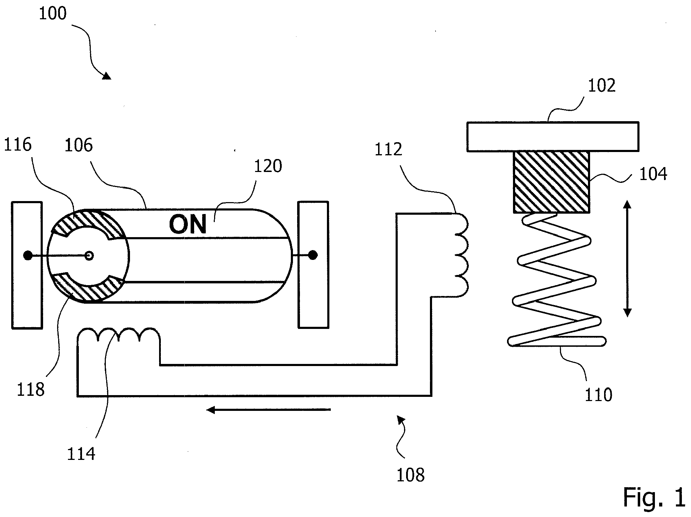

Figure 1 schematically illustrates an exemplary indicator arrangement 100 for indicating a state associated with a button 102 of an electronic device. The indicator arrangement 100 comprises a button-related magnet 104 arranged to be movable by the button 102 when the button is pressed, an indicator element 106 switchable between two states associated with the button 102, and a switching arrangement 108 configured to switch the indicator element 106 using electrical energy induced by a magnetic field of the button-related magnet 104 when the button 102 is pressed. In the illustrated example, the button-related magnet 104 is arranged underneath the button 102 and attached to the button 102 so that the button-related magnet 104 moves in the stroke direction of the button 102 when the button 102 is pressed. A resilient element 110 (here indicated as a spring for illustration purposes only) is provided to force back the button 102 into its original position when the button 102 is released after it has been pressed. The button-related magnet 104 may be a static magnet.

For generating electrical energy induced by the magnetic field of the button-related magnet 104, the indicator arrangement 100 generally makes use of the physical principle according to which an electrical current can be induced in a conducting loop if the conducting loop is exposed to a changing magnetic field. Such change in the magnetic field may be effected by moving the conducting loop in and out of the magnetic field or, more generally, by altering the distance between the magnet and the conducting loop, for example.

For generating electrical energy using this principle, the button-related magnet 104 may be moved in relation to a coil 112 of the switching arrangement 108, wherein electrical energy is induced in the coil 112 by the magnetic field of the button-related magnet 104 when the button 102 is pressed. The coil 112 is arranged in a way that, when the button 102 is pressed, the button-related magnet 104 is moved next to the windings of the coil 112 and, when the button 102 is released, the button-related magnet 104 is removed from the windings of the coil 112. In this way, the coil 112 gets into and out of the magnetic field of the button-related magnet 104 when the button 102 is actuated and a corresponding electrical current is thus induced in the coil 112.

The induced electrical energy is subsequently used for generating a magnetic force that, in turn, is used to switch the indicator element 106. The switching arrangement 108 comprises for this purpose an inductor 114 which is electrically connected to the coil 112. The electrical energy induced in the coil 112 is thus transmitted to the inductor 114 when the button 102 is pressed, and a magnetic field for switching the indicator element 106 is generated by the inductor 114 using the induced electrical energy. In the illustrated example, the inductor 114 is positioned below the indicator element 106 so that the magnetic field generated by the inductor 114 may exert a magnetic force on the inductor element 106 that switches the inductor element 106 from one indicator position to another.

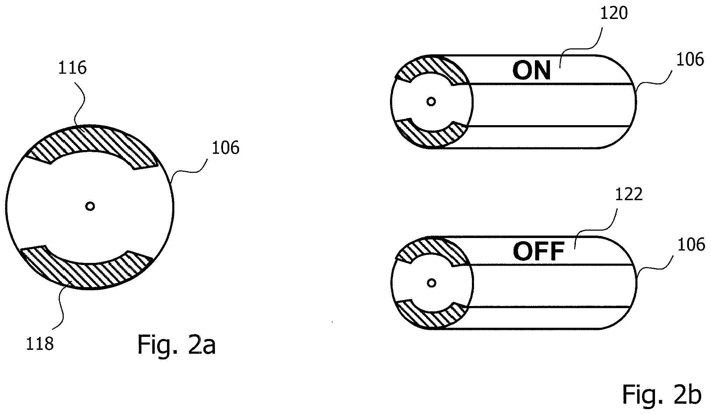

In the example shown, the indicator element 106 has a cylindrical form and is configured to be rotatable about its longitudinal axis. Two brackets that support the indicator element 106 are schematically shown on both ends of the indicator element 106. The indicator element 106 comprises two indicator-related magnets 116 and 118 which are arranged at circumferential portions of the indicator element 106. The indicator-related magnets 116 and 118 are spaced apart from each other in the circumferential direction of the indicator element 106 and, more specifically, the indicator-related magnets 116 and 118 are arranged at opposite sides in the circumferential direction of the indicator element 106 (better visible in Figure 2a which shows the indicator element 106 in a cross-sectional view) so that each press of the button 102 effects a half turn of the indicator element 106, i.e., from one indicator position to the other. Both the indicator-related magnets 116 and 118 may be static magnets.

In detail, when the button 102 is pressed, the button-related magnet 104 is moved next to the windings of the coil 112 (i.e., the coil 112 gets into the magnetic field of the button-related magnet 104) and the changing magnetic field generates an electrical current in the coil 112 which is transmitted to the inductor 114. The electric current then generates a magnetic field by the inductor 114 which exerts a magnetic force on the indicator-related magnets 116 and 118 to switch the indicator element 106 from one indicator position to the other.

Assuming that the magnetic field generated by the inductor 114 has the same magnetic polarity as the indicator-related magnet 116, the magnetic field generated by the inductor 114 pushes the indicator-related magnet 116 away from the inductor 114. This situation is shown in Figure 1. On the other hand, when the button 102 is released, the button-related magnet 104 is removed from the windings of the coil 112 (i.e., the coil 112 gets out of the magnetic field of the button-related magnet 104). At this time, an electrical current is again generated in the coil 112, but with a reverse polarity so that the magnetic polarity of the magnetic field generated by the inductor 114 is reversed. As shown in Figure 1, the magnetic field generated by the inductor 114 then pulls the other inductor-related magnet 118 to the inductor 114 (assuming that the indicator-related magnet 118 has the same magnetic polarity as the indicator-related magnet 116) and thereby causes the rotating indicator element 106 to stop. As a result, each press of the button 102 brings about a half turn of the indicator element 106, i.e., from one indicator position to the other.

Figure 2a illustrates a detailed cross-sectional view of the indicator element 106 which shows that the indicator-related magnets 116 and 118 are arranged at opposite sides in the circumferential direction of the indicator element 106. Figure 2b illustrates a detailed perspective view of the indicator element 106, wherein the upper portion of Figure 2b shows the indicator element 106 in an indicator position which corresponds to an "ON" state associated with the button 102 and the lower portion of Figure 2b shows the indicator element 106 in an indicator position which corresponds to an "OFF" state associated with the button 102. These "ON" and "OFF" states may correspond to respective states of the electronic device selected by the button 102. If the electronic device is a keyboard of a laptop or personal computer and the button corresponds to the "numlock" key of the keyboard, for example, the state of the electronic device may correspond to the numeric keypad being active or inactive (i.e., "ON" or "OFF"), depending on the selection made by a user using the "numlock" key of the keyboard.

As illustrated in Figure 2b, the selected states are visible to the user by static visual indications which do not require electrical energy for being permanently displayed to the user. In particular, the static visual indications correspond to labels 120 and 122, i.e., "ON" and OFF" labels, which are alternatingly displayed to the user each time the button 102 is pressed.

As has become apparent from the above, by using electrical energy generated by pressing the button 102, the indicator element 106 may be switched without making use of the actual power supply of the underlying electronic device and the energy consumption of the electronic device may therefore be reduced. In other words, it may be said that the indicator arrangement 100 produces electrical energy required for switching the indicator element 106 on its own when the button 102 is pressed so that the indicator element 106 can be switched without the need for an external energy source.

The electronic device may be any electronic device which comprises at least one button and a corresponding indicator that indicates a state associated with the button, e.g., a state of the electronic device selected by pressing the button. The electronic device may be, but is not limited to, a smartphone, tablet, laptop, personal computer, TV, set-top box, refrigerator, cooker, dishwasher, washing machine, air conditioner, for example. If the electronic device is a laptop or a personal computer, the button may be a key of the corresponding keyboard, for example.

It is believed that the advantages of the technique presented herein will be fully understood from the foregoing description, and it will be apparent that various changes may be made in the form, constructions and arrangement of the exemplary aspects thereof without departing from the scope of the disclosure or without sacrificing all of its advantageous effects. Because the technique presented herein can be varied in many ways, it will be recognized that the disclosure should be limited only by the scope of the claims that follow.

## Claims

1. An indicator arrangement (100) for indicating a state associated with a button (102) of an electronic device, the indicator arrangement (100) comprising:
a button-related magnet (104) arranged to be movable by the button (102) when the button (102) is pressed;
an indicator element (106) switchable between at least two states associated with the button (102); and
a switching arrangement (108) configured to switch the indicator element (106) using electrical energy induced by a magnetic field of the button-related magnet (104) when the button (102) is pressed.

2. The indicator arrangement (100) of claim 1, wherein the switching arrangement (108) comprises a coil (112) and the electrical energy is induced in the coil (112) by the magnetic field of the button-related magnet (104) when the button (102) is pressed.

3. The indicator arrangement (100) of claim 1 or 2, wherein the button-related magnet (104) is attached to the button (102) and moved into a stroke direction of the button (102) when the button (102) is pressed.

4. The indicator arrangement (100) of any one of claims 1 to 3, wherein the switching arrangement (108) comprises an inductor (114), wherein the induced electrical energy is transmitted to the inductor (114), and wherein a magnetic field for switching the indicator element (106) is generated by the inductor (114) using the induced electrical energy.

5. The indicator arrangement (100) of claim 4, wherein the indicator element (106) comprises at least one indicator-related magnet (116, 118), and wherein the magnetic field generated by the inductor (114) exerts a magnetic force on the at least one indicator-related magnet (116, 118) to switch the indicator element (106) from one indicator position to another.

6. The indicator arrangement (100) of claim 5, wherein the indicator element (106) is rotatable, and wherein the at least one indicator-related magnet (116, 118) is arranged at the indicator element (106) to rotate the indicator element (106) from one indicator position to another each time the button (102) is pressed.

7. The indicator arrangement (100) of claim 6, wherein the indicator element (106) comprises at least two indicator-related magnets (116, 118) arranged at circumferential portions of the indicator element (106), wherein each pair among the at least two indicator-related magnets (116, 118) is spaced apart from one another in a circumferential direction of the indicator element (106).

8. The indicator arrangement (100) of any one of claims 1 to 7, wherein each indicator position of the indicator element (106) corresponds to a state associated with the button (102).

9. The indicator arrangement (100) of any one of claims 1 to 8, wherein the state associated with the button (102) corresponds to a state of the electronic device selected by the button (102).

10. An electronic device comprising the indicator arrangement (100) of any one of claims 1 to 9.

## Amended claims

### Amended claims in accordance with Rule 137(2) EPC.

1. An indicator arrangement (100) for indicating a state associated with a button (102) of an electronic device, the indicator arrangement (100) comprising:
a button-related magnet (104) arranged to be movable by the button (102) when the button (102) is pressed;
an indicator element (106) switchable between at least two states associated with the button (102),
**characterized in that** the indicator arrangement (100) further comprises:
a switching arrangement (108) configured to switch the indicator element (106) using electrical energy induced by a magnetic field of the button-related magnet (104) when the button (102) is pressed.

2. The indicator arrangement (100) of claim 1, wherein the switching arrangement (108) comprises a coil (112) and the electrical energy is induced in the coil (112) by the magnetic field of the button-related magnet (104) when the button (102) is pressed.

3. The indicator arrangement (100) of claim 1 or 2, wherein the button-related magnet (104) is attached to the button (102) and moved into a stroke direction of the button (102) when the button (102) is pressed.

4. The indicator arrangement (100) of any one of claims 1 to 3, wherein the switching arrangement (108) comprises an inductor (114), wherein the induced electrical energy is transmitted to the inductor (114), and wherein a magnetic field for switching the indicator element (106) is generated by the inductor (114) using the induced electrical energy.

5. The indicator arrangement (100) of claim 4, wherein the indicator element (106) comprises at least one indicator-related magnet (116, 118), and wherein the magnetic field generated by the inductor (114) exerts a magnetic force on the at least one indicator-related magnet (116, 118) to switch the indicator element (106) from one indicator position to another.

6. The indicator arrangement (100) of claim 5, wherein the indicator element (106) is rotatable, and wherein the at least one indicator-related magnet (116, 118) is arranged at the indicator element (106) to rotate the indicator element (106) from one indicator position to another each time the button (102) is pressed.

7. The indicator arrangement (100) of claim 6, wherein the indicator element (106) comprises at least two indicator-related magnets (116, 118) arranged at circumferential portions of the indicator element (106), wherein each pair among the at least two indicator-related magnets (116, 118) is spaced apart from one another in a circumferential direction of the indicator element (106).

8. The indicator arrangement (100) of any one of claims 1 to 7, wherein each indicator position of the indicator element (106) corresponds to a state associated with the button (102).

9. The indicator arrangement (100) of any one of claims 1 to 8, wherein the state associated with the button (102) corresponds to a state of the electronic device selected by the button (102).

10. An electronic device comprising the indicator arrangement (100) of any one of claims 1 to 9.
